# EUROPEAN PATENT APPLICATION

(11) **EP 4 842 174 A1**
(43) Date of publication of application: **18.11.2026**
(21) Application number: 26153308.7
(22) Date of filing: 21.01.2026
(51) Int. Cl.: H10K 59/12, H10K 71/10, H10W 46/00

(54) **DISPLAY DEVICE AND ELECTRONIC DEVICE INCLUDING THE SAME**

(30) Priority: 15.05.2025 KR 20250063161
(71) Applicant: Samsung Display Co., Ltd., Yongin-si, Gyeonggi-do 17113 (KR)
(72) Inventor: MA, Hyung Gun, 17113 Yongin-si (KR)
(74) Representative: Marks & Clerk LLP

(57) **Abstract**

A display device includes: a substrate; a light-emitting element on a display area of the substrate; a first reflective pattern on the substrate and arranged throughout an alignment area included in a non-display area surrounding the display area; and a second reflective pattern on the first reflective pattern, exposing the first reflective pattern, including an alignment key formed in a recessed pattern, and including a material having a different reflectivity from the first reflective pattern.

## Description

### BACKGROUND

### 1. Field

Aspects of some embodiments of the present disclosure relate to a display device and an electronic device including the display device.

### 2. Description of the Related Art

With the growing interest in information displays in recent years, research and development on display devices have been continuously conducted.

The above information disclosed in this Background section is only for enhancement of understanding of the background and therefore the information discussed in this Background section does not necessarily constitute prior art.

### SUMMARY

Aspects of some embodiments of the present disclosure include a display device with relatively improved reliability and an electronic device including the display device.

According to one or more embodiments of the present disclosure, a display device includes: a substrate, a light-emitting element on a display area of the substrate, a first reflective pattern on the substrate and arranged throughout an alignment area included in a non-display area surrounding the display area, and a second reflective pattern on the first reflective pattern, exposing the first reflective pattern, including an alignment key formed in a recessed pattern, and including a material having a different reflectivity from the first reflective pattern.

According to some embodiments, the alignment key may be defined as an opening penetrating the second reflective pattern.

According to some embodiments, a reflectivity of the first reflective pattern may be greater than a reflectivity of the second reflective pattern.

According to some embodiments, the first reflective pattern may include a metal, and the second reflective pattern may include a metal compound.

According to some embodiments, the first reflective pattern may include aluminium, and the second reflective pattern may include titanium nitride.

According to some embodiments, the display device may further include a wiring portion between the substrate and the first reflective pattern and in the non-display area.

According to some embodiments, the wiring portion may overlap the first reflective pattern and the second reflective pattern.

According to some embodiments, the wiring portion may include aluminium.

According to some embodiments, a thickness of the wiring portion may be greater than a thickness of the first reflective pattern.

According to some embodiments, the thickness of the first reflective pattern may be in a range of 500 angstroms to 1000 angstroms (or about 500 angstroms to about 1000 angstroms).

According to some embodiments, the display device may further include a pixel circuit layer between the substrate and the light-emitting element and including a transistor electrically connected to the light-emitting element.

According to some embodiments, the display device may further include a reflective electrode between the pixel circuit layer and the light-emitting element and electrically connected to the transistor and the light-emitting element.

According to some embodiments, the light-emitting element may include: an anode electrode on the reflective electrode and electrically connected to the reflective electrode, an emission structure on the anode electrode, and a cathode electrode on the emission structure.

According to some embodiments, the reflective electrode may be on a same layer as the first reflective pattern and may include a same material as the first reflective pattern.

According to some embodiments, the reflective electrode may include aluminium.

According to some embodiments, edge ends of the first reflective pattern and edge ends of the second reflective pattern may align with each other.

According to one or more embodiments of the present disclosure, an electronic device includes: a processor and a display device configured to display an image under control of the processor.

According to some embodiments, the display device includes: a substrate, a light-emitting element on a display area of the substrate, a first reflective pattern on the substrate and arranged throughout an alignment area included in a non-display area surrounding the display area, and a second reflective pattern on the first reflective pattern, exposing the first reflective pattern, including an alignment key formed in a recessed pattern, and including a material having a different reflectivity from the first reflective pattern.

According to some embodiments, the alignment key may be defined as an opening penetrating the second reflective pattern.

According to some embodiments, a reflectivity of the first reflective pattern may be greater than a reflectivity of the second reflective pattern.

According to some embodiments, edge ends of the first reflective pattern and edge ends of the second reflective pattern may align with each other.

At least some of the above and other features of the invention are set out in the claims.

### BRIEF DESCRIPTION OF THE DRAWINGS

The above and other aspects and characteristics of some embodiments of the present disclosure will be more clearly understood from the following detailed description of the illustrative, non-limiting embodiments with reference to the accompanying drawings.
FIG. 1 is a block diagram of a display device according to some embodiments of the present disclosure.
FIG. 2 is a plan view of a display panel of FIG. 1 according to some embodiments of the present disclosure.
FIG. 3 is an exploded view of a display unit of FIG. 1 according to some embodiments of the present disclosure.
FIG. 4 is a plan view of sub-pixels according to some embodiments of the present disclosure.
FIG. 5 is a cross-sectional view taken along the line I-I' of FIG. 4 according to some embodiments of the present disclosure.
FIG. 6 is a plan view of an enlarged view of the area A in FIG. 2 according to some embodiments of the present disclosure.
FIG. 7 is a cross-sectional view taken along the line II-II' of FIG. 6 according to some embodiments of the present disclosure.
FIG. 8 is a block diagram of an electronic device according to some embodiments of the present disclosure.
FIG. 9 is a drawing of electronic devices according to some embodiments of the present disclosure.

### DETAILED DESCRIPTION

The disclosure will now be described more fully hereinafter with reference to the accompanying drawings, in which various embodiments according to the present disclosure are shown. This disclosure may, however, be embodied in many different forms, and should not be construed as limited to the embodiments set forth herein. Rather, these embodiments are provided so that this disclosure will be thorough and complete, and will fully convey the scope of the disclosure to those skilled in the art.

In describing the drawings, like reference numerals have been used for like elements. In the accompanying drawings, the dimensions of the structures are enlarged than the actual size in order to clearly explain the disclosure. It will be understood that, although the terms "first", "second", etc. may be used herein to describe various elements, these elements should not be limited by these terms. These terms are only used to distinguish one element from another element. For instance, a first element discussed below could be termed a second element without departing from the scope of the disclosure. Similarly, the second element could also be termed the first element.

The terminology used herein is for the purpose of describing particular embodiments only and is not intended to be limiting. As used herein, "a", "an", "the", and "at least one" do not denote a limitation of quantity, and are intended to include both the singular and plural, unless the context clearly indicates otherwise. For example, "an element" has the same meaning as "at least one element", unless the context clearly indicates otherwise. "At least one" is not to be construed as limiting "a" or "an". "Or" means "and/or". As used herein, the term "and/or" includes any and all combinations of one or more of the associated listed items. It will be further understood that the terms "comprises" and/or "comprising", or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the following description, when a first part is "connected" to a second part, this includes not only the case where the first part is directly connected to the second part, but also the case where a third part is interposed therebetween and they are connected to each other.

Furthermore, relative terms, such as "lower" or "bottom" and "upper" or "top" may be used herein to describe one element's relationship to another element as illustrated in the drawing figures. It will be understood that relative terms are intended to encompass different orientations of the device in addition to the orientation depicted in the drawing figures. For example, if the device in one of the drawing figures is turned over, elements described as being on the "lower" side of other elements would then be oriented on "upper" sides of the other elements. The term "lower" may therefore, encompass both an orientation of "lower" and "upper" depending on the particular orientation of the figure. Similarly, when the device in one of the drawing figures is turned over, elements described as "below" or "beneath" other elements would then be oriented "above" the other elements. The terms "below" or "beneath" may, therefore, encompass both an orientation of above and below.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Hereinafter, embodiments of the disclosure will be described in detail with reference to the accompanying drawings.

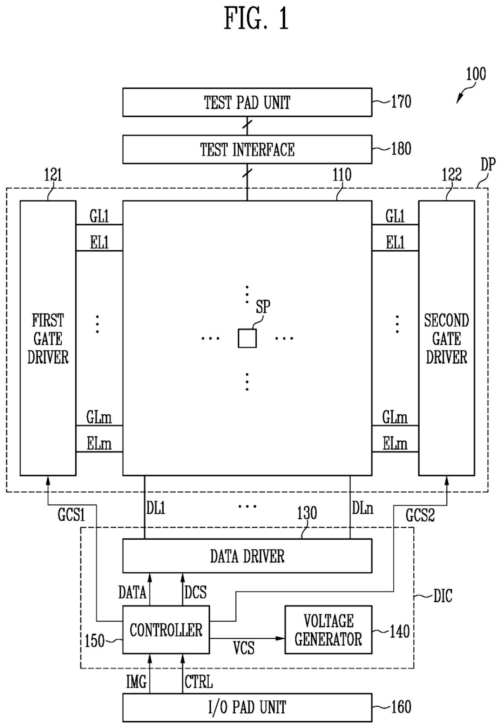

FIG. 1 is a block diagram of a display device according to some embodiments of the present disclosure.

Referring to FIG. 1, the display device 100 may include a display unit 110, first and second gate drivers 121, 122, a data driver 130, a voltage generator 140, a controller 150, and an input/output (I/O) pad unit 160, although embodiments according to the present disclosure are not limited thereto, and according to some embodiments, the display device 100 may include additional components, or fewer components, without departing from the scope of embodiments according to the present disclosure.

The display unit 110 may include sub-pixels SP. The sub-pixels SP may be arranged in a zigzag pattern along a row direction and a column direction. For example, the sub-pixels SP may be arranged in a PENTILE^{™} pattern. However, the embodiments according to the present disclosure are not limited thereto. For example, the sub-pixels SP may be arranged in a matrix pattern along the row direction and the column direction.

The sub-pixels SP may be connected to the first and second gate drivers 121, 122 through first to m-th gate lines GL1 to GLm. The sub-pixels SP may be connected to the data driver 130 through first to n-th data lines DL1 to DLn.

Each of the sub-pixels SP may include at least one light-emitting element configured to generate light. Accordingly, each of the sub-pixels SP may generate light of a specific color, such as red, green, blue, cyan, magenta, yellow, and the like. A unit comprising two or more sub-pixels SP may be provided as a single pixel. Accordingly, the single pixel may emit light of various colors. In this way, the display device 100 may display an image through the display unit 110.

The display unit 110 may have various shapes. The display unit 110 may have a closed-loop shape including straight and/or curved edges. For example, the display unit 110 may have shapes such as a polygon, a circle, a semicircle, an ellipse, and the like.

The display unit 110 may be used as a display screen for a virtual reality (VR) device, a mixed reality (MR) device, an augmented reality (AR) device, and the like. For example, the display unit 110 may be used as a display screen for a head-mounted display (HMD). In such cases, the sub-pixels SP with relatively high density may be required. To increase the density of the sub-pixels SP, the sub-pixels SP may be formed on a silicon substrate. The display device 100 including the sub-pixels SP formed on the silicon substrate may be referred to as an OLED on Silicon (OLEDoS) display device.

The first gate driver 121 may be connected to the sub-pixels SP arranged in the row direction through the first to m-th gate lines GL1 to GLm. The second gate driver 122 may be connected to the sub-pixels SP arranged in the row direction through the first to m-th gate lines GL1 to GLm. However, the embodiments according to the present disclosure are not limited thereto. The first and second gate drivers 121, 122 may be connected to different gate lines. For example, the first gate driver 121 may be connected to odd-numbered gate lines, and the second gate driver 122 may be connected to even-numbered gate lines.

The first and second gate drivers 121, 122 may each operate in response to control from the controller 150. The first gate driver 121 may output gate signals to the first to m-th gate lines GL1 to GLm in response to a first gate control signal GCS1 from the controller 150. The second gate driver 122 may output gate signals to the first to m-th gate lines GL1 to GLm in response to a second gate control signal GCS2 from the controller 150. The first and second gate control signals GCS1, GCS2 may each include a start signal indicating the start of each frame, a horizontal synchronization signal for outputting gate signals in synchronization with the timing at which data signals are applied, and the like.

First to m-th emission control lines EL1 to ELm connected to the sub-pixels SP in the row direction may further be provided. In such cases, each of the first and second gate drivers 121, 122 may include an emission control driver configured to control the first to m-th emission control lines EL1 to ELm under the control of the controller 150. However, the embodiments according to the present disclosure are not limited thereto. For example, the emission control driver of the first gate driver 121 may be connected to odd-numbered emission control lines, and the emission control driver of the second gate driver 122 may be connected to even-numbered emission control lines.

The first gate driver 121 may be located on one side of the display unit 110, and the second gate driver 122 may be located on the other side of the display unit 110. However, the embodiments according to the present disclosure are not limited thereto. For example, the display device 100 may include only one gate driver located on one side of the display unit 110.

The display unit 110 and the first and second gate drivers 121, 122 may be formed in a single display panel DP. The display unit 110 may be located in a display area of the display panel DP. Accordingly, the display panel DP may display an image through the display area. The first and second gate drivers 121, 122 may be located in a non-display area of the display panel DP surrounding the display area. However, the embodiments according to the present disclosure are not limited thereto. Additional components may be included in the display panel DP. For example, the display panel DP may further include at least one of a driver integrated circuit DIC, the input/output pad unit 160, a test pad unit 170, or a test interface 180 in the non-display area.

The display area of the display panel DP may be flat. However, the embodiments according to the present disclosure are not limited thereto. For example, the display area of the display panel DP may have at least a partially rounded shape. The display panel DP may be bendable, foldable, or rollable. In such cases, the display panel DP may include materials having flexible properties.

The data driver 130 may be connected to the sub-pixels SP arranged in the column direction through the first to n-th data lines DL1 to DLn. The data driver 130 may receive image data DATA and a data control signal DCS from the controller 150. The data driver 130 may operate in response to the data control signal DCS. The data control signal DCS may include a source start pulse, a source shift clock, a source output enable signal, and the like.

The data driver 130 may apply data signals having grayscale voltages corresponding to the image data DATA to the first to n-th data lines DL1 to DLn using voltages from the voltage generator 140. When a gate signal is applied to each of the first to m-th gate lines GL1 to GLm, data signals corresponding to the image data DATA may be applied to the first to n-th data lines DL1 to DLn. As a result, the corresponding sub-pixels SP may generate light corresponding to the data signals. As a result, images may be displayed on the display unit 110.

The first and second gate drivers 121, 122 and the data driver 130 may include complementary metal-oxide semiconductor (CMOS) circuit elements.

A demux circuit may be provided between the data driver 130 and the display unit 110. The demux circuit may demultiplex the data signals from the data driver 130 and output them to the first to n-th data lines DL1 to DLn.

The voltage generator 140 may operate in response to a voltage control signal VCS from the controller 150. The voltage generator 140 may receive an external voltage through the input/output pad unit 160 and generate multiple voltages using the received external voltage. The generated voltages may be provided to the components of the display device 100. Some of the voltages provided to the components of the display device 100 may be voltages received through the input/output pad unit 160.

The controller 150 may control various operations of the display device 100. The controller 150 may receive input image data IMG and a control signal CTRL for controlling its display from an external source through the input/output pad unit 160. The controller 150 may provide the first and second gate control signals GCS1, GCS2, the data control signal DCS, and the voltage control signal VCS in response to the control signal CTRL.

The controller 150 may convert the input image data IMG into a format suitable for the display device 100 (or display unit 110) and output the image data DATA. For example, the controller 150 may align the input image data IMG into rows of the sub-pixels SP and output the image data DATA.

The display device 100 may further include a temperature sensor. The controller 150 may receive temperature data from the temperature sensor and control the components of the display device 100 according to the received temperature data.

Two or more of the components of the data driver 130, the voltage generator 140, and the controller 150 may be mounted on a single integrated circuit. As shown in FIG. 1, the data driver 130, the voltage generator 140, and the controller 150 may be included in the driver integrated circuit DIC. In such cases, the data driver 130, the voltage generator 140, and the controller 150 may be functionally distinct components in the driver integrated circuit DIC. The driver integrated circuit DIC may further include first and second gate drivers 121, 122. At least one of the first or second gate drivers 121, 122, the data driver 130, the voltage generator 140, or the controller 150 may be provided as components separate from the driver integrated circuit DIC.

The driver integrated circuit DIC may be located between the display unit 110 and the input/output pad unit 160. In FIG. 1, the driver integrated circuit DIC may be shown separately from the display panel DP. However, the embodiments according to the present disclosure are not limited thereto. The driver integrated circuit DIC may be designed as an integral part of the display panel DP. For example, the input/output pad unit 160 may be located along an outer perimeter of the non-display area of the display panel DP, and the driver integrated circuit DIC may be located between the display unit 110 and the input/output pad unit 160 in the non-display area.

The input/output pad unit 160 may include a plurality of pads. Each of the pads may receive signals or voltages from an external source. Thus, the input/output pad unit 160 may receive the signals and voltages from the external source and transmit the received signals and voltages to components of the display device 100. For example, the input/output pad unit 160 may include pads for receiving the input image data IMG and the control signal CTRL. For example, the input/output pad unit 160 may include pads for receiving voltages.

The display device 100 may further include the test pad unit 170 and the test interface 180. The test pad unit 170 may include a plurality of pads.

The pads of the test pad unit 170 may receive test signals from the sub-pixels SP through the test interface 180. The test interface 180 may include a multiplex circuit. When a test module is connected to the pads of the test pad unit 170, the test module may receive the test signals from the sub-pixels SP through the test pad unit 170 and the test interface 180 to test whether the sub-pixels SP are normal. However, the embodiments according to the present disclosure are not limited thereto. For example, the test module may apply test signals to the sub-pixels SP through the test pad unit 170 and the test interface 180 to measure a luminance of light emitted from the sub-pixels SP. Additionally, the test module connected to the test pad unit 170 may receive signals from components of the display device 100 or apply signals to components of the display device 100 for various testing purposes.

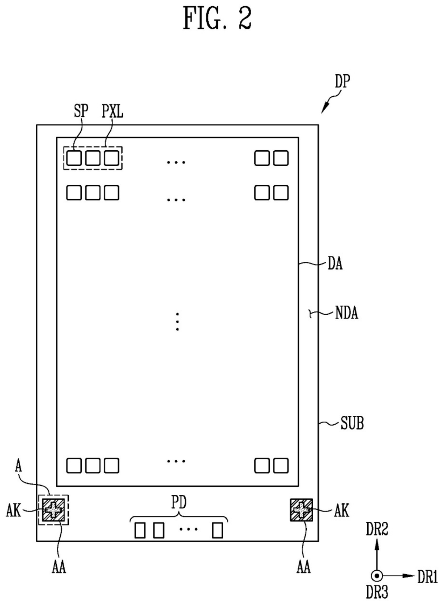

FIG. 2 is a plan view of a display panel of FIG. 1 according to some embodiments of the present disclosure.

Referring to FIG. 2, the display panel DP of FIG. 1 may include a display area DA and a non-display area NDA. The display panel DP may display images through the display area DA. The non-display area NDA may be arranged around (e.g., in a periphery, or outside a footprint of) the display area DA.

The display panel DP may include a substrate SUB, the sub-pixels SP, and pads PD.

When the display panel DP may be used as a display screen for a head-mounted display (HMD), a virtual reality (VR) device, a mixed reality (MR) device, an augmented reality (AR) device, and the like, the display panel DP may be positioned very close to the user's eyes. In such cases, the sub-pixels SP with relatively high density may be required. To increase the density of the sub-pixels SP, the substrate SUB may be provided as a silicon substrate. The sub-pixels SP and/or the display panel DP may be formed on the silicon substrate SUB. The display device 100 (refer to FIG. 1) including the display panel DP formed on the silicon substrate SUB may be referred to as an OLED on Silicon (OLEDoS) display device.

The sub-pixels SP may be arranged in the display area DA on the substrate SUB. The sub-pixels SP may be arranged in a matrix form or arrangement of a plurality of rows and columns arranged along a first direction DR1 and a second direction DR2 intersecting the first direction DR1. However, the embodiments according to the present disclosure are not limited thereto. For example, the sub-pixels SP may be arranged in a zigzag pattern along the first direction DR1 and the second direction DR2. For example, the sub-pixels SP may be arranged in a PENTILE^{™} pattern. The first direction DR1 may be the row direction, and the second direction DR2 may be the column direction.

Two or more of the sub-pixels SP may form a single pixel PXL.

Components for controlling the sub-pixels SP may be arranged in the non-display area NDA of the substrate SUB. For example, wirings connected to sub-pixels SP such as the first to m-th gate lines GL1 to GLm and the first to n-th data lines DL1 to DLn of FIG. 1 may be arranged in the non-display area NDA.

At least one of the first or second gate drivers 121, 122, the data driver 130, the voltage generator 140, the controller 150, or the input/output pad unit 160 of FIG. 1 may be integrated into the non-display area NDA of the display panel DP. The first and second gate drivers 121, 122 of FIG. 1 may be mounted on the display panel DP and may be located in the non-display area NDA. The first and second gate drivers 121, 122 may be implemented as integrated circuits separate from the display panel DP.

The pads PD may be arranged in the non-display area NDA on the substrate SUB. The pads PD may be electrically connected to the sub-pixels SP through the wirings. For example, the pads PD may be connected to the sub-pixels SP through the first to n-th data lines DL1 to DLn (refer to FIG. 1).

The pads PD may interface the display panel DP with other components of the display device 100 (refer to FIG. 1). Voltages and signals required for the operation of components included in the display panel DP may be provided from the driver integrated circuit DIC of FIG. 1 through the pads PD. For example, the first to n-th data lines DL1 to DLn (refer to FIG. 1) may be connected to the driver integrated circuit DIC (refer to FIG. 1) through the pads PD. For example, When the first and second gate drivers 121, 122 (refer to FIG. 1) are mounted on the display panel DP, the first and second gate control signals GCS1, GCS2 (refer to FIG. 1) may be transmitted from the driver integrated circuit DIC to the first and second gate drivers 121, 122 through the pads PD.

Conductive adhesive materials such as anisotropic conductive films may be used to electrically connect a circuit board to the pads PD. In such cases, the circuit board may be a flexible circuit board (FPCB) or a flexible film made of a flexible material. The driver integrated circuit DIC may be mounted on the circuit board and electrically connected to the pads PD.

The non-display area NDA may include alignment areas AA. Each of the alignment areas AA may be adjacent to the display area DA and the pads PD. Alignment keys AK may each arranged on the alignment areas AA on the substrate SUB. Each of the alignment keys AK may be defined as parts of the alignment areas AA and may be arranged symmetrically with respect to a center line of the display panel DP extending in the second direction DR2. The alignment keys AK may serve to align equipment or components during the manufacturing of the display panel DP. The equipment may set its position based on the alignment keys AK by recognizing the alignment keys AK, thereby relatively improving the reliability of the manufacturing process of the display panel DP.

The display area DA may have various shapes. The display area DA may have a closed-loop shape including straight and/or curved edges. For example, the display area DA may have shapes such as a polygon, a circle, a semicircle, ellipse, and the like.

The display panel DP may have a flat display surface. However, the embodiments according to the present disclosure are not limited thereto. For example, the display panel DP may have at least a partially rounded display surface. The display panel DP may be bendable, foldable, or rollable. In such cases, the display panel DP and/or the substrate SUB may include materials having flexible properties.

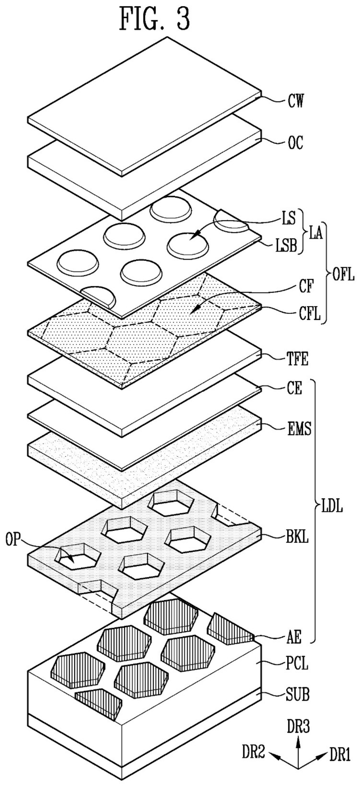

FIG. 3 is an exploded view of a display unit of FIG. 1 according to some embodiments of the present disclosure. In FIG. 3, for clarity and simplicity, only a portion of the display unit 110 corresponding to some of the sub-pixels SP of FIG. 1 is shown schematically. The remaining portions of the display unit 110 corresponding to the other sub-pixels SP may be similarly configured.

Referring to FIG. 3, the display unit 110 may include a substrate SUB, a pixel circuit layer PCL, a light-emitting element layer LDL, an encapsulation layer TFE, an optical function layer OFL, an overcoat layer OC, and a cover window CW.

The pixel circuit layer PCL may be located on the substrate SUB. Conductive patterns and semiconductor patterns included in the substrate SUB and/or the pixel circuit layer PCL may function as circuit elements. The circuit elements may be included in sub-pixel circuits corresponding to the sub-pixels. Wirings of the pixel circuit layer PCL may include signal lines connected to the sub-pixel circuits, such as gate lines, emission control lines, data lines, and pre-voltage lines.

The light-emitting element layer LDL may include anode electrodes AE, a bank layer BKL, an emission structure EMS, and a cathode electrode CE.

The anode electrodes AE may be arranged on the pixel circuit layer PCL. The anode electrodes AE may be connected to the circuit elements of the pixel circuit layer PCL. The anode electrodes AE may include an opaque conductive material capable of reflecting light, but the embodiments according to the present disclosure are not limited thereto.

In FIG. 3, the anode electrodes AE having hexagonal shapes are shown as example embodiments. However, the embodiments according to the present disclosure are not limited thereto. The anode electrodes AE may be modified into various shapes such as a circular, a square, and the like.

The bank layer BKL may be arranged on the anode electrodes AE. The bank layer BKL may include openings OP respectively overlapping the anode electrodes AE. The openings OP may expose portions of the anode electrodes AE. Depending on the openings OP of the bank layer BKL, emission areas corresponding to the sub-pixels may be defined. In areas adjacent to edges of the anode electrodes AE, the bank layer BKL may include a separator that causes a discontinuity to form within the emission structure EMS. In such cases, it may be understood the emission areas corresponding to the sub-pixels are defined based on the separator of the bank layer BKL.

In FIG. 3, the openings OP having hexagonal shapes are shown as example embodiments. However, the embodiments according to the present disclosure are not limited thereto. The openings OP may be modified into various shapes such as a circular, a square, and the like.

The emission structure EMS may be located on the bank layer BKL. The emission structure EMS may include an emission layer configured to generate light, an electron transport layer configured to transport electrons, and a hole transport layer configured to transport holes.

The emission structure EMS may be arranged on the anode electrodes AE by filling the openings OP of the bank layer BKL, and may be arranged uniformly over an entire upper surface of the bank layer BKL. In other words, the emission structure EMS may be arranged across the sub-pixels in their entirety. In such cases, at least some of the layers within the emission structure EMS may be interrupted or bent at boundaries between the sub-pixels due to the separator of the bank layer BKL. However, the embodiments according to the present disclosure are not limited thereto. For example, emission layers may be provided on the anode electrodes AE in the openings OP. In such cases, each of the emission layers may be configured to emit light of one of colors such as red, green, and blue.

The cathode electrode CE may be located on the emission structure EMS. The cathode electrode CE may be provided as a common electrode for the sub-pixels.

The cathode electrode CE may be a thin metal layer having a thickness sufficient to allow light emitted from the emission structure EMS to pass through. The cathode electrode CE may be formed from a metal material having a relatively thin thickness or from a transparent conductive material. For example, the cathode electrode CE may include at least one of various transparent conductive materials such as indium tin oxide, indium zinc oxide, indium tin zinc oxide, aluminium zinc oxide, gallium zinc oxide, zinc tin oxide, gallium tin oxide, and/or the like. For example, the cathode electrode CE may include at least one of silver (Ag), magnesium (Mg), and/or mixtures thereof. The cathode electrode CE may have a multi-layered structure. For example, the cathode electrode CE may include a first layer comprising indium zinc oxide and a second layer comprising a silver-magnesium (Ag-Mg) alloy. For example, the cathode electrode CE may further include a capping layer on top of the first layer and the second layer, which may function to output light toward the front. However, the embodiments according to the present disclosure are not limited thereto.

Any one of the anode electrodes AE, a portion of the emission structure EMS overlapping thereon, and a portion of the cathode electrode CE overlapping thereon may be understood to constitute a single light-emitting element.

The encapsulation layer TFE may be located on the cathode electrode CE. The encapsulation layer TFE may cover the light-emitting element layer LDL and the pixel circuit layer PCL. The encapsulation layer TFE may be configured to prevent or reduce contaminants such as oxygen and moisture penetrating into the light-emitting element layer LDL. The encapsulation layer TFE may include a structure alternately layered with one or more inorganic films and one or more organic films. For example, the inorganic films may include silicon nitride, silicon oxide, or silicon oxynitride (SiOxNy). For example, the organic layers may include acrylic resin, epoxy resin, phenolic resin, polyamide resin, polyimide resin, unsaturated polyester resin, polyphenylenether resin, polyphenylenesulfide resin, or benzocyclobutene. However, the materials of the organic and inorganic films of the encapsulation layer TFE are not limited thereto.

To relatively improve encapsulation efficiency of the encapsulation layer TFE, the encapsulation layer TFE may further include a thin film including aluminium oxide. The thin film including aluminium oxide may be located on an upper surface of the encapsulation layer TFE facing the optical functional layer OFL and/or on a lower surface of the encapsulation layer TFE facing the light-emitting element layer LDL.

The thin film including aluminium oxide may be formed using atomic layer deposition (ALD). However, the embodiments according to the present disclosure are not limited thereto. The encapsulation layer TFE may further include a thin film formed from at least one material suitable for relatively improving encapsulation efficiency.

The optical functional layer OFL may be located on the encapsulation layer TFE. The optical functional layer OFL may include a color filter layer CFL and a lens array LA.

The color filter layer CFL may be located between the encapsulation layer TFE and the lens array LA. The color filter layer CFL may be configured to selectively output light corresponding to wavelength range or color of each sub-pixel by filtering light emitted from the emission structure EMS. The color filter layer CFL may include color filters CF respectively overlapping the openings OP. Each of the color filters CF may be capable of transmitting light within the wavelength range corresponding to the respective sub-pixel. For example, a first color filter may transmit red light, a second color filter may transmit blue light, and a third color filter may transmit green light. Depending on the light emitted from the emission structure EMS of each of the sub-pixels, at least some of the color filters CF may be omitted.

The color filters CF may have the same shape as the openings OP. However, the embodiments according to the present disclosure are not limited thereto, and the color filters CF may be modified into various shapes.

In areas between adjacent color filters CF, materials of the adjacent color filters CF may overlap. In such cases, overlapping portions of the adjacent color filters CF may function as a light-blocking layer.

The sub-pixel circuit of the pixel circuit layer PCL, the light-emitting element of the light-emitting element layer LDL, and the color filter CF corresponding to the light-emitting element may be understood as constituting a single sub-pixel.

The lens array LA may be arranged on the color filter layer CFL. The lens array LA may include a base layer LSB extending along the first and second directions DR1, DR2, and lenses LS arranged on the base layer LSB. The lenses LS may overlap the color filters CF, respectively. Each of the lenses LS may relatively improve emission efficiency by outputting light emitted from the emission structure EMS along an intended path. The lenses LS may include an organic material. For example, the lenses LS may include an acrylic material. However, the material of the lenses LS is not limited thereto.

In FIG. 3, the lenses LS having circular shapes are shown as example embodiments. Each of the lenses LS may have a trapezoidal shape in a cross-sectional view. However, the embodiments according to the present disclosure are not limited thereto. The lenses LS may be modified into various shapes. For example, each of the lenses LS may have a polygonal shape in a plan view, and may have a semicircular shape or a rounded shape in the cross-sectional view.

The lenses LS may be arranged on the base layer LSB and formed integrally with the base layer LSB. For example, the base layer LSB and the lenses LS may include the same material. However, the embodiments according to the present disclosure are not limited thereto. For example, the base layer LSB may be omitted.

The overcoat layer OC may be located on the lens array LA. The overcoat layer OC may cover the optical functional layer OFL, the encapsulation layer TFE, the emission structure EMS, and/or the pixel circuit layer PCL. The overcoat layer OC may include various materials suitable for protecting its underlying layers from contaminants such as dust and moisture. For example, the overcoat layer OC may include at least one of an inorganic insulating film or an organic insulating film. For example, the overcoat layer OC may include epoxy resin, but the embodiments according to the present disclosure are not limited thereto.

The cover window CW may be located on the overcoat layer OC. The cover window CW may be configured to protect its lower layers. The cover window CW may include glass, but the embodiments according to the present disclosure are not limited thereto. For example, the cover window CW may be an encapsulation glass configured to protect the components located beneath it. The cover window CW may be omitted.

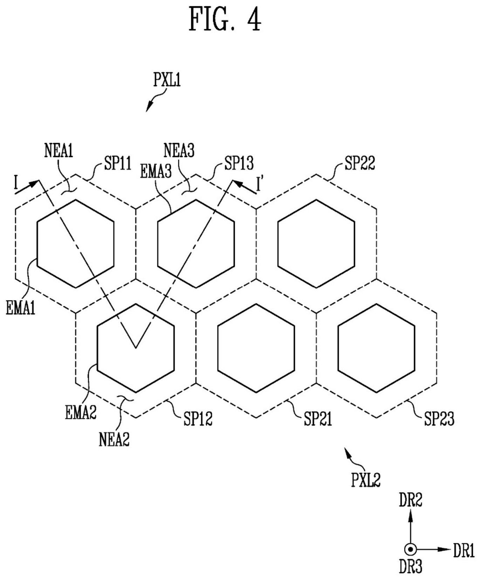

FIG. 4 is a plan view of sub-pixels according to some embodiments of the present disclosure.

In FIG. 4, for clarity and simplicity, the sub-pixels included in two pixels PXL1, PXL2 are shown, but the sub-pixels of the remaining pixels may be similarly configured.

Referring to FIG. 4, a first pixel PXL1 may include first to third sub-pixels SP11 to SP13.

The first sub-pixel SP11 may include a first emission area EMA1 and a first non-emission area NEA1 surrounding the first emission area EMA1. The second sub-pixel SP12 may include a second emission area EMA2 and a second non-emission area NEA2 surrounding the second emission area EMA2. The third sub-pixel SP13 may include a third emission area EMA3 and a third non-emission area NEA3 surrounding the third emission area EMA3.

The first emission area EMA1 may be an area from which light is emitted from a portion of the emission structure EMS (refer to FIG. 3) corresponding to the first sub-pixel SP11. The emitted light may, for example, pass through a red color filter to express a red color. The second emission area EMA2 may be an area from which light is emitted from a portion of the emission structure EMS corresponding to the second sub-pixel SP12. The emitted light may, for example, pass through a green color filter to express a green color. The third emission area EMA3 may be an area from which light is emitted from a portion of the emission structure EMS corresponding to the third sub-pixel SP13. The emitted light may, for example, pass through a blue color filter to express a blue color.

In FIG. 4, the first to third emission areas EMA1 to EMA3 are shown as having hexagonal shapes. However, the embodiments according to the present disclosure are not limited thereto. The first to third emission areas EMA1 to EMA3 may be modified into various shapes such as circles, squares, and the like. For example, the shapes of the first to third emission areas EMA1 to EMA3 may be determined based on planar shapes of the openings OP of FIG. 3.

The second pixel PXL2 may include the first to third sub-pixels SP21 to SP23. The first to third sub-pixels SP21 to SP23 of the second pixel PXL2 may be configured in the same manner as the first to third sub-pixels SP11 to SP13 of the first pixel PXL1. The first sub-pixel SP21 of the second pixel PXL2 may express red light. The second sub-pixel SP22 of the second pixel PXL2 may express green light. The third sub-pixel SP23 of the second pixel PXL2 may express blue light.

Each of the sub-pixels SP11 to SP13, SP21 to SP23 may have a hexagonal shape. However, the embodiments according to the present disclosure are not limited thereto. Each of the sub-pixels SP11 to SP13, SP21 to SP23 may have any one of various polygonal shapes.

Each of the sub-pixels SP11 to SP13, SP21 to SP23 may have the same size. However, the embodiments according to the present disclosure are not limited thereto. The first to third emission areas EMA1 to EMA3 may have different sizes.

The sub-pixels SP11 to SP13, SP21 to SP23 may be arranged in a zigzag pattern along the first and second directions DR1, DR2. However, the embodiments according to the present disclosure are not limited thereto. For example, the sub-pixels SP11 to SP13, SP21 to SP23 may be arranged in a matrix pattern along the first and second directions DR1, DR2. Additionally, the arrangement of the sub-pixels SP11 to SP13, SP21 to SP23 may be varied in various ways.

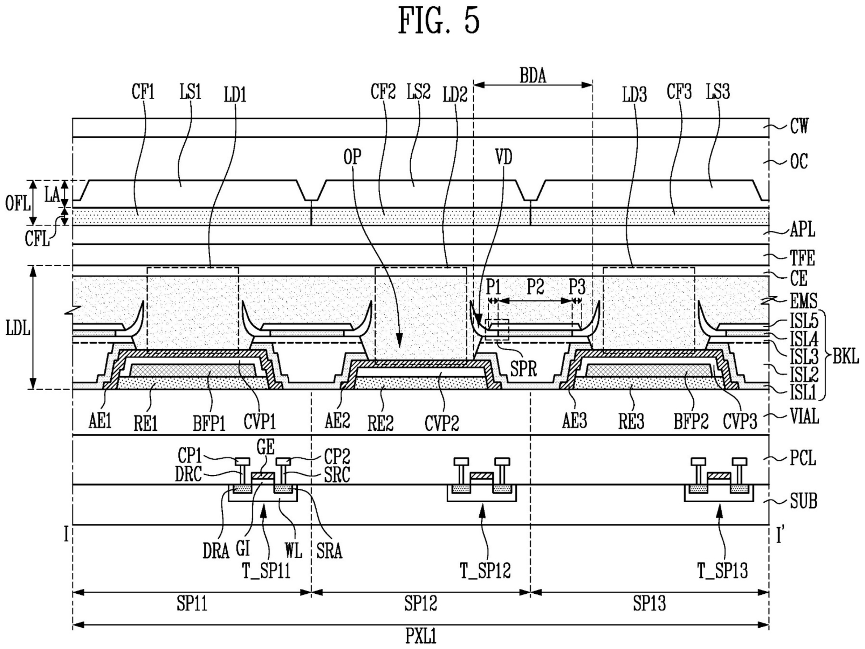

FIG. 5 is a cross-sectional view taken along the line I-I' of FIG. 4 according to some embodiments of the present disclosure.

Referring to FIG. 5, a substrate SUB and a pixel circuit layer PCL arranged on the substrate SUB are provided.

The substrate SUB may include a silicon wafer substrate formed using a semiconductor process. The substrate SUB may include a semiconductor material suitable for forming circuit devices. For example, the semiconductor material may include silicon, germanium, and/or silicon-germanium. The substrate SUB may be provided from bulk wafers, epitaxial layers, Silicon On Insulator (SOI) layers, or Semiconductor On Insulator (SeOl) layers. The substrate SUB may include a glass substrate. The substrate SUB may include a Polyimide (PI) substrate.

The pixel circuit layer PCL may be located on the substrate SUB. The substrate SUB and the pixel circuit layer PCL may include circuit elements for each of the first to third sub-pixels SP11 to SP13. For example, the substrate SUB and the pixel circuit layer PCL may include a transistor T_SP11 of the first sub-pixel SP11, a transistor T_SP12 of the second sub-pixel SP12, and a transistor T_SP13 of the third sub-pixel SP13. The transistor T_SP11 of the first sub-pixel SP11 may be any one of transistors included in the sub-pixel circuit of the first sub-pixel SP11. The transistor T_SP12 of the second sub-pixel SP12 may be any one of transistors included in the sub-pixel circuit of the second sub-pixel SP12. The transistor T_SP13 of the third sub-pixel SP13 may be any one of transistors included in the sub-pixel circuit of the third sub-pixel SP13. In FIG. 5, for clarity and brevity, one of the transistors of each sub-pixel is shown, and illustration and description of some other circuit elements may be omitted.

The transistor T_SP11 of the first sub-pixel SP11 may include a source area SRA, a drain area DRA, and a gate electrode GE.

The source area SRA and the drain area DRA may be located within the substrate SUB. A well WL formed by an ion implantation process may be located within the substrate SUB, and the source area SRA and the drain area DRA may be arranged in spaced-apart positions within the well WL. An area between the source area SRA and the drain area DRA within the well WL may be defined as a channel area. The gate electrode GE may overlap the channel area between the source area SRA and the drain area DRA and may be located in the pixel circuit layer PCL. The gate electrode GE may be spaced apart from the well WL or the channel region by an insulating material such as a gate insulating layer GI. The gate electrode GE may include a conductive material.

A plurality of layers included in the pixel circuit layer PCL may include conductive patterns arranged between insulating layers, and the conductive patterns may include first and second conductive patterns CP1, CP2. The first conductive pattern CP1 may be electrically connected to the drain area DRA through a drain connection DRC that penetrates one or more insulating layers. The second conductive pattern CP2 may be electrically connected to the source area SRA through a source connection SRC that penetrates one or more insulating layers.

The gate electrode GE and the first and second conductive patterns CP1, CP2 may be connected to other circuit elements and/or wiring, and the transistor T_SP11 of the first sub-pixel SP11 may be provided as any one of the transistors of the first sub-pixel SP11.

The transistor T_SP12 of the second sub-pixel SP12 and the transistor T_SP13 of the third sub-pixel SP13 may each be configured in the same manner as the transistor T_SP11 of the first sub-pixel SP11.

In this way, the substrate SUB and the pixel circuit layer PCL may include the circuit elements of each of the first to third sub-pixels SP11 to SP13.

A via layer VIAL may be located on the pixel circuit layer PCL. The via layer VIAL may cover the pixel circuit layer PCL and may have a generally flat surface. The via layer VIAL may be configured to flatten steps on the pixel circuit layer PCL. The via layer VIAL may include at least one of silicon oxide (SiOx), silicon nitride (SiNx), or silicon carbon nitride (SiCN), but the embodiments according to the present disclosure are not limited thereto.

A light-emitting element layer LDL may be located on the via layer VIAL. The light-emitting element layer LDL may include first to third reflective electrodes RE1 to RE3, first and second buffer patterns BFP1, BFP2, first to third cover patterns CVP1 to CVP3, first to third anode electrodes AE1 to AE3, a bank layer BKL, an emission structure EMS, and a cathode electrode CE.

On the via layer VIAL, the first to third reflective electrodes RE1 to RE3 may be arranged in the first to third sub-pixels SP11 to SP13, respectively. Each of the first to third reflective electrodes RE1 to RE3 may contact the circuit elements located in the pixel circuit layer PCL through a via penetrating the via layer VIAL.

The first to third reflective electrodes RE1 to RE3 may be configured to reflect light emitted from the emission structure EMS toward a display surface (or the cover window CW). The first to third reflective electrodes RE1 to RE3 may include metal materials suitable for reflecting light. The first to third reflective electrodes RE1 to RE3 may include aluminium (Al), silver (Ag), magnesium (Mg), platinum (Pt), palladium (Pd), gold (Au), nickel (Ni), neodymium (Nd), iridium (Ir), chromium (Cr), titanium (Ti), and alloys of two or more of these materials, but the embodiments according to the present disclosure are not limited thereto.

A connection electrode may be located between each of the first to third reflective electrodes RE1 to RE3 and the via layer VIAL. The connection electrode may relatively improve the electrical connection characteristics between the corresponding reflective electrode and the circuit elements of the pixel circuit layer PCL. The connection electrode may have a multi-layered structure. The multi-layered structure may include titanium (Ti), titanium nitride (TiN), tantalum nitride (TaN), and the like, but the embodiments according to the present disclosure are not limited thereto. The corresponding reflective electrode may be positioned between the multi-layers of the connection electrode.

A buffer pattern may be arranged on at least one of the first to third reflective electrodes RE1 to RE3. For example, the first and second buffer patterns BFP1, BFP2 may be arranged on the first and third reflective electrodes RE1, RE3, respectively. Heights of the first and third anode electrodes AE1, AE3 in the third direction DR3 may be adjusted by the first and second buffer patterns BFP1, BFP2. The first and second buffer patterns BFP1, BFP2 may include inorganic materials such as silicon oxide (SiOx) and silicon nitride (SiNx), but the embodiments according to the present disclosure are not limited thereto.

The first to third cover patterns CVP1 to CVP3 may be located on the first to third reflective electrodes RE1 to RE3, respectively. In the first sub-pixel SP11, the first cover pattern CVP1 may be located on the first reflective electrode RE1 and the first buffer pattern BFP1. In the second sub-pixel SP12, the second cover pattern CVP2 may be located on the second reflective electrode RE2. In the third sub-pixel SP13, the third cover pattern CVP3 may be located on the third reflective electrode RE3 and the second buffer pattern BFP2. The first to third cover patterns CVP1 to CVP3 may be formed after the formation of the first and second buffer patterns BFP1, BFP2 during a manufacturing process. The first to third cover patterns CVP1 to CVP3 may include the same material as the first and second buffer patterns BFP1, BFP2. For example, the first to third cover patterns CVP1 to CVP3 may include inorganic materials such as silicon oxide (SiOx) and silicon nitride (SiNx), but the embodiments according to the present disclosure are not limited thereto.

The first to third anode electrodes AE1 to AE3 may be located on the first to third cover patterns CVP1 to CVP3, respectively. The first anode electrode AE1 may cover the first cover pattern CVP1, the first buffer pattern BFP1, and the first reflective electrode RE1. The second anode electrode AE2 may cover the second cover pattern CVP2 and the second reflective electrode RE2. The third anode electrode AE3 may cover the third cover pattern CVP3, the second buffer pattern BFP2, and the third reflective electrode RE3.

The first to third anode electrodes AE1 to AE3 may be electrically connected to the first to third reflective electrodes RE1 to RE3, respectively. For example, each anode electrode may be connected to an end (or edge) of the corresponding reflective electrode. However, the embodiments according to the present disclosure are not limited thereto. To relatively improve the electrical connection characteristics between the first to third anode electrodes AE1 to AE3 and the first to third reflective electrodes RE1 to RE3, the first to third anode electrodes AE1 to AE3 may be connected to the first to third reflective electrodes RE1 to RE3 in various ways.

The first to third anode electrodes AE1 to AE3 may include transparent conductive materials such as indium tin oxide (ITO), indium zinc oxide (IZO), zinc oxide (ZnOx), indium gallium zinc oxide (IGZO), indium tin zinc oxide (ITZO), and the like. However, the materials of the first to third anode electrodes AE1 to AE3 are not limited thereto. For example, the first to third anode electrodes AE1 to AE3 may include titanium nitride.

The first to third anode electrodes AE1 to AE3 and the cathode electrode CE may partially reflect incident light. Light emitted from the emission layer of the emission structure EMS may be amplified by traveling back and forth between the corresponding anode electrode and the cathode electrode CE, and may be output through the cathode electrode CE. For example, each anode electrode and cathode electrode CE may provide a resonant structure in the corresponding sub-pixel. In such cases, a distance between each anode electrode and cathode electrode CE may be understood as a resonant distance for light emitted from the emission layer of the emission structure EMS.

The first to third sub-pixels SP11 to SP13 may correspond to red, green, and blue, respectively. In such cases, the heights of the first and third anode electrodes AE1, AE3 in the third direction DR3 may be higher than that of the second anode electrode AE2 due to the first and second buffer patterns BFP1, BFP2. As a result, the first and third sub-pixels SP11, SP13 may have a shorter resonant distance than the second sub-pixel SP12 due to the first and second buffer patterns BFP1, BFP2. In this way, the resonant distance of each sub-pixel may be adjusted to effectively and efficiently amplify light within the wavelength range of the corresponding color.

In FIG. 5, the first and second buffer patterns BFP1, BFP2 are located below the first and third anode electrodes AE1, AE3, respectively, but the embodiments according to the present disclosure are not limited thereto. For example, one of the first and second buffer patterns BFP1, BFP2 may be omitted. For example, both the first and second buffer patterns BFP1, BFP2 may be omitted. In such a case, the resonant distance between each anode electrode and the cathode electrode CE may be the same. For example, buffer patterns having different thicknesses may be located below the first to third anode electrodes AE1 to AE3, respectively. In such a case, the resonant distance between each anode electrode and the cathode electrode CE may be different from one another. In this way, by providing a buffer pattern beneath at least one of the first to third anode electrodes AE1 to AE3 to adjust the height of the corresponding anode electrode, the resonant distance at each sub-pixel may be optimized.

The bank layer BKL may be located on the first to third anode electrodes AE1 to AE3 and the via layer VIAL. The bank layer BKL may have the openings OP exposing portions of the first to third anode electrodes AE1 to AE3. An area overlapping the bank layer BKL may be understood as a boundary area BDA between adjacent sub-pixels.

The bank layer BKL may include multiple inorganic insulating layers stacked sequentially. Each of the multiple inorganic insulating layers may include at least one of silicon oxide (SiOx) or silicon nitride (SiNx). However, the embodiments according to the present disclosure are not limited thereto. For example, the bank layer BKL may include an organic insulating layer.

The bank layer BKL may include first to fifth inorganic insulating layers ISL1 to ISL5. The first inorganic insulating layer ISL1 may cover portions of the first to third anode electrodes AE1 to AE3 and the via layer VIAL.

The second inorganic insulating layer ISL2 may be located on the first inorganic insulating layer ISL1. The second inorganic insulating layer ISL2 may be located on the first inorganic insulating layer ISL1 and may provide a top surface having a uniform height overall. As described above, even if the heights of some of the first to third anode electrodes AE1 to AE3 are different, the second inorganic insulating layer ISL2 may provide the top surface having the uniform height across the boundary area BDA.

The third inorganic insulating layer ISL3 may be located on the second inorganic insulating layer ISL2, the fourth inorganic insulating layer ISL4 may be located on the third inorganic insulating layer ISL3, and the fifth inorganic insulating layer ISL5 may be located on the fourth inorganic insulating layer ISL4.

The first and fourth inorganic insulating layers ISL1, ISL4 may include silicon nitride (SiNx). The second and third inorganic insulating layers ISL2, ISL3 may include silicon oxide (SiOx). The second and third inorganic insulating layers ISL2, ISL3 may be formed through separate manufacturing processes and may contain the same material. In such cases, a boundary between the second and third inorganic insulating layers ISL2, ISL3 may not be visible. The fifth inorganic insulating layer ISL5 may include silicon oxide (SiOx).

In FIG. 5, the bank layer BKL is shown to include the first to fifth inorganic insulating layers ISL1 to ISL5, but the embodiments according to the present disclosure are not limited thereto. For example, some of the first to fifth inorganic insulating layers ISL1 to ISL5 may be omitted. For example, the bank layer BKL may include a greater number of inorganic insulating layers.

The emission structure EMS may be located on the first to third anode electrodes AE1 to AE3. The emission structure EMS may fill the openings OP of the bank layer BKL and be arranged entirely across the first to third sub-pixels SP11 to SP13.

The emission structure EMS may include two emission units stacked sequentially, and each emission unit may include an emission layer configured to generate light in response to an applied current. According to some embodiments, the emission structure EMS may include three emission units stacked sequentially, and each emission unit may include an emission layer configured to generate light in response to an applied current. The light emitted from the emission layers of the emission units may be mixed to output white light.

The emission structure EMS may be formed through processes such as vacuum deposition, inkjet printing, and the like.

The bank Layer BKL may include a separator SPR in the boundary area BDA. The separator SPR may cause discontinuous portions such as voids VD to form in the emission structure EMS. Due to the discontinuous portions, at least some of the multiple layers included in the emission structure EMS may be broken or bent.

The fifth inorganic insulating layer ISL5 may include first to third portions P1 to P3. The second portion P2 may completely overlap the fourth inorganic insulating layer ISL4. The first portion P1 may protrude from one side of the second portion P2. The third portion P3 may protrude from the opposite side of the second portion P2. Thus, a width of the fifth inorganic insulating layer ISL5 may be wider than that of the fourth inorganic insulating layer ISL4. For example, during the manufacturing process, the fourth inorganic insulating layer ISL4 may be undercut so as not to include portions overlapping the first and third portions P1, P3. For example, each of the first and third portions P1, P3 of the fifth inorganic insulating layer ISL5 may have an eave-shaped configuration on the fourth inorganic insulating layer ISL4, and the eave-shaped configuration may be provided as the separator SPR. The separator SPR may be arranged adjacent to openings OP.

Due to the separator SPR, the voids VD may form adjacent to the separator SPR in the emission structure EMS. The voids VD may, for example, be air gaps. Due to the voids VD, some of the multiple layers stacked within the emission structure EMS may be broken or bent. For example, at least one charge generation layer and at least one hole injection layer included in the emission structure EMS may be disconnected by the voids VD. As such, portions of the emission structure EMS corresponding to the first to third sub-pixels SP11 to SP13 may be partially separated from each other. Accordingly, in the first sub-pixel SP11, the first anode electrode AE1, a portion of the emission structure EMS overlapping the first anode electrode AE1, and a portion of the cathode electrode CE overlapping the first anode electrode AE1 may form a first light-emitting element LD1. In the second sub-pixel SP12, the second anode electrode AE2, a portion of the emission structure EMS overlapping the second anode electrode AE2, and a portion of the cathode electrode CE overlapping the second anode electrode AE2 may form a second light-emitting element LD2. In the third sub-pixel SP13, the third anode electrode AE3, a portion of the emission structure EMS overlapping the third anode electrode AE3, and a portion of the cathode electrode CE overlapping the third anode electrode AE3 may form a third light-emitting element LD3. The phenomenon of leakage current occurring through a specific layer of the emission structure EMS between the first to third light-emitting elements LD1 to LD3 may be prevented or reduced by the voids VD.

The bank layer BKL may have one or more trenches as an additional separator in the boundary area BDA. The trenches may penetrate one or more of the first to fifth inorganic insulating layers ISL1 to ISL5. Due to the trenches, some of the multiple layers included in the emission structure EMS, such as at least one charge generation layer and at least one hole injection layer, may be broken or bent. As a result, the phenomenon of leakage current occurring through a specific layer of the emission structure EMS between the first to third light-emitting elements LD1 to LD3 may be further prevented or reduced.

The cathode electrode CE may be located on the emission structure EMS. The cathode electrode CE may be provided in common to the first to third sub-pixels SP11 to SP13.

The encapsulation layer TFE may be located on the cathode electrode CE. The encapsulation layer TFE may prevent or reduce contaminants such as oxygen and/or moisture penetrating into the light-emitting element layer LDL.

The optical functional layer OFL may be located on the encapsulation layer TFE. The optical functional layer OFL may be attached to the encapsulation layer TFE through an adhesive layer APL. For example, the optical functional layer OFL may be separately manufactured and attached to the encapsulation layer TFE through the adhesive layer APL. The adhesive layer APL may further perform a function of protecting lower layers including the encapsulation layer TFE.

The optical functional layer OFL may include a color filter layer CFL and a lens array LA. The color filter layer CFL may include first to third color filters CF1 to CF3 corresponding to first to third sub-pixels SP11 to SP13, respectively. The first to third color filters CF1 to CF3 may transmit light in different wavelength ranges. For example, the first to third color filters CF1 to CF3 may transmit light of red, green, and blue colors, respectively.

The first to third color filters CF1 to CF3 may partially overlap in the boundary area BDA. According to some embodiments, the first to third color filters CF1 to CF3 may be spaced apart, and a black matrix may be provided between the first to third color filters CF1 to CF3.

The lens array LA may be located on the color filter layer CFL. The lens array LA may include first to third lenses LS1 to LS3 corresponding to first to third sub-pixels SP11 to SP13, respectively. The first to third lenses LS1 to LS3 may relatively improve emission efficiency by outputting light emitted from the first to third light-emitting elements LD1 to LD3 along the intended path.

The overcoat layer OC may be located on the lens array LA. The overcoat layer OC may be configured to protect lower layers from foreign substances such as dust and moisture. The cover window CW may be located on the overcoat layer OC.

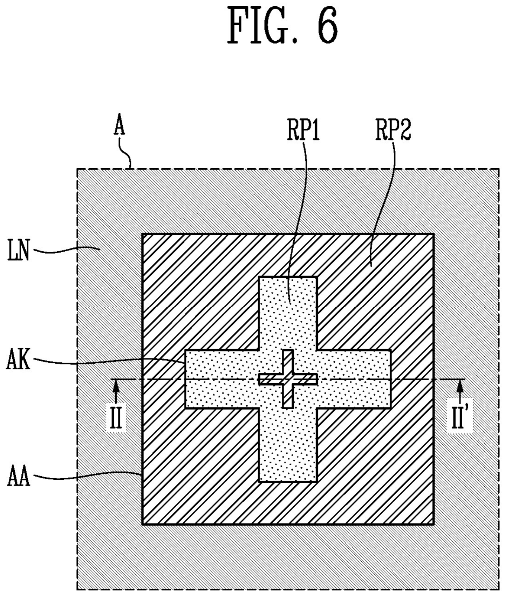

FIG. 6 is a plan view of an enlarged view of area A in FIG. 2 according to some embodiments of the present disclosure.

Referring to FIGS. 2 and 6, the alignment key AK may be defined on a portion of the alignment area AA on the substrate SUB. For example, a first reflective pattern RP1 may be arranged across the alignment area AA on the substrate SUB. A second reflective pattern RP2 may be arranged on the first reflection pattern RP1.

The second reflective pattern RP2 may be formed in a recessed pattern to include the alignment key AK exposing the first reflective pattern RP1. The alignment key AK may be defined as an opening penetrating the second reflective pattern RP2. In such cases, the second reflective pattern RP2 may include a material having a different reflectivity from the first reflective pattern RP1. Through the alignment key AK, the first reflective pattern RP1 having a different reflectivity from the second reflective pattern RP2 may be exposed. The manufacturing equipment may recognize the alignment key AK by detecting a difference in reflectivity between the first reflective pattern RP1 and the second reflective pattern RP2 due to the first reflective pattern RP1 having a shape of the alignment key AK and a reflectivity different from that of the second reflective pattern RP2 that defines the alignment key AK.

The alignment key AK may have various shapes. In FIG. 6, the alignment key AK is shown in a cross shape, but the shape of the alignment key AK may be not limited thereto. Additionally, the alignment key AK may be composed of a single or multiple units. That is, the alignment key AK may be composed of one or more alignment patterns. Shapes of the alignment patterns may be the same or different.

A reflectivity of the first reflective pattern RP1 may be greater than a reflectivity of the second reflective pattern RP2. For example, the first reflective pattern RP1 may include a metal with high reflectivity, and the second reflective pattern RP2 may include a metal compound. For example, the first reflective pattern RP1 may include aluminium (Al), and the second reflective pattern RP2 may include at least one of titanium nitride (TiN), titanium (Ti), tantalum (Ta), or tantalum nitride (TaN). However, the embodiments according to the present disclosure are not limited thereto.

The second reflective pattern RP2 may fully overlap the first reflective pattern RP1. For example, edge ends of the first reflective pattern RP1 and edge ends of the second reflective pattern RP2 may align with each other. However, the embodiments according to the present disclosure are not limited thereto. According to some embodiments, the second reflective pattern RP2 including the alignment key AK may cover the first reflective pattern RP1 entirely. That is, an area of the second reflective pattern RP2 including the alignment key AK may be larger than an area of the first reflective pattern RP1, and the edge ends of the second reflective pattern RP2 may protrude beyond the edge ends of the first reflective pattern RP1.

A wiring portion LN may be located between the substrate SUB and the first reflective pattern RP1. The wiring portion LN may be located in the non-display area NDA and may include wirings or electrodes that transmit voltages and signals to wirings, circuit elements, or light-emitting elements of the display device 100. For example, the wiring portion LN may be electrically connected to a transistor T_SP or a light-emitting element LD and may include pads PD and a power wiring for supplying power.

The wiring portion LN may overlap the first reflective pattern RP1 and the second reflective pattern RP2. However, the embodiments according to the present disclosure are not limited thereto. The wiring portion LN may not overlap the first reflective pattern RP1 and the second reflective pattern RP2.

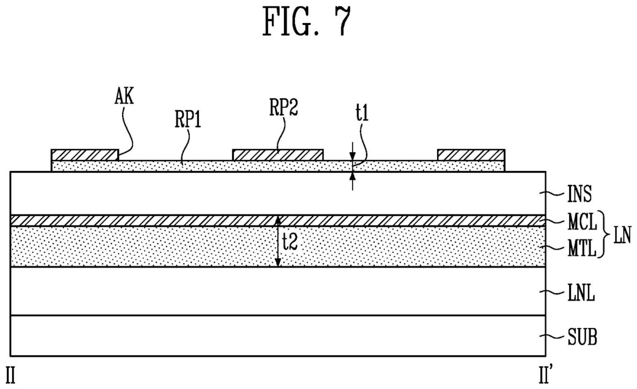

FIG. 7 is a cross-sectional view taken along the line II-II' of FIG. 6 according to some embodiments of the present disclosure.

Referring to FIG. 7, a wiring layer LNL extended from the pixel circuit layer PCL (refer to FIG. 3) of the display area DA (refer to FIG. 2) may be located in the non-display area NDA (refer to FIG. 2) on the substrate SUB. That is, the wiring layer LNL may be located on the same layer as the pixel circuit layer PCL of the display area DA. In such cases, the wiring layer LNL may include wirings and insulating layers located on the same layer as the pixel circuit layer PCL of the display area DA.

The wiring portion LN may be located on the wiring layer LNL. The wiring portion LN may be located in the non-display area NDA and may not be located in the display area DA. The wiring portion LN may be electrically connected to the wirings and electrodes of the wiring layer LNL. The wiring portion LN may be electrically connected to the wirings and electrodes of the wiring layer LNL to transmit a power voltage. As a result, the area of the wiring that transmits the power voltage may increase, thereby reducing the wiring resistance. In FIG. 7, the wiring portion LN is shown to overlap the first reflective pattern RP1 and the second reflective pattern RP2, but the embodiments according to the present disclosure are not limited thereto. The wiring portion LN may not overlap the first reflective pattern RP1 and the second reflective pattern RP2 and may be spaced apart on a plane.

The wiring portion LN may include a metal layer MTL and a metal compound layer MCL located on the metal layer MTL and covering the metal layer MTL. For example, the metal layer MTL may include aluminium, and the metal compound layer MCL may include at least one of titanium nitride, titanium, tantalum, or tantalum nitride to prevent or reduce oxidation of the metal layer MTL.

The wiring portion LN and the first reflective pattern RP1 may include the same material. For example, the metal layer MTL of the wiring portion LN and the first reflective pattern RP1 may include the same material (e.g., aluminium).

An insulating layer INS may be located on the wiring portion LN. For example, the insulating layer INS in the non-display area NDA may be the same layer as the via layer VIAL (refer to FIG. 5) in the display area DA, and may extend from at least a portion of the via layer VIAL in the display area DA. However, the embodiments according to the present disclosure are not limited thereto.

The first reflective pattern RP1 may be located on the insulating layer INS. The first reflective pattern RP1 may be located on the same layer as the first to third reflective electrodes RE1 to RE3 (refer to FIG. 5). Accordingly, the first reflective pattern RP1 may include the same material as the first to third reflective electrodes RE1 to RE3 (refer to FIG. 5) of the display area DA.

A thickness t2 of the wiring portion LN may be greater than a thickness t1 of the first reflective pattern RP1. For example, a thickness of the metal layer MTL of the wiring portion LN may be greater than the thickness t1 of the first reflective pattern RP1. For example, the thickness of the metal layer MTL of the wiring portion LN may be 6 times (or about 6 times) or more greater than the thickness t1 of the first reflective pattern RP1.

The thickness t1 of the first reflective pattern RP1 may be in a range of 500 angstroms to 1000 angstroms (or about 500 angstroms to about 1000 angstroms). When the thickness t1 of the first reflective pattern RP1 may be less than 500 angstroms (or about 500 angstroms), the thickness of each of the first to third reflective electrodes RE1 to RE3 in the display area DA, which are the same layer, may also be less than 500 angstroms (or about 500 angstroms). In such cases, the reflectivity of each of the first to third reflective electrodes RE1 to RE3 in the display area DA may decrease, making them unsuitable for reflecting light. Additionally, it may be difficult to control the thickness variation of each of the first to third reflective electrodes RE1 to RE3 (refer to FIG. 5). When the thickness t1 of the first reflective pattern RP1 may be greater than 1,000 angstroms (or about 1,000 angstroms), the thickness of each of the first to third reflective electrodes RE1 to RE3 (refer to FIG. 5) in the display area DA, which are the same layer, may also be greater than 1,000 angstroms (or about 1,000 angstroms). In such cases, the thickness of each of the first to third reflective electrodes RE1 to RE3 may become excessively large, making it difficult to form each of the first to third reflective electrodes RE1 to RE3 at the micro-scale.

The thickness of the metal layer MTL included in the wiring portion LN may be in a range of 5,000 angstroms to 12,000 angstroms (or about 5,000 angstroms to about 12,000 angstroms). However, the embodiments according to the present disclosure are not limited thereto.

The second reflective pattern RP2 may be located on the first reflective pattern RP1. The second reflective pattern RP2 may expose the first reflective pattern RP1 through the alignment key AK.

The first reflective pattern RP1 and the second reflective pattern RP2 may be electrically insulated from other conductive layers (e.g., the wiring portion LN and the wiring layer LNL). However, the embodiments according to the present disclosure are not limited thereto. According to some embodiments, the first reflective pattern RP1 and the second reflective pattern RP2 may be electrically connected to other conductive layers.

The first reflective pattern RP1 may cover the wiring portion LN (or wiring layer LNL), and the second reflective pattern RP2 may include the alignment key AK exposing the first reflective pattern RP1, thereby enabling the alignment key AK formed in the recessed pattern to be easily recognized due to the difference in reflectivity between the first reflective pattern RP1 and the second reflective pattern RP2. That is, unlike the wiring portion LN (or wiring layer LNL), the reflectivity of the second reflective pattern RP2 adjacent to the alignment key AK may be relatively small, and the reflectivity of the first reflective pattern RP1 exposed by the alignment key AK may be relatively large. Therefore, the misrecognition of the alignment key AK due to reflection from the wiring portion LN and the wiring layer LNL may be reduced. As a result, the recognition rate of the alignment key AK may increase, thereby relatively improving the reliability of the display device 100.

Additionally, by designing the first reflective pattern RP1 and second reflective pattern RP2 that constitute the alignment key AK and the wiring portion LN as separate layers, the layout freedom of the wirings may be increased. In other words, because the layout of the wirings may be designed without considering the alignment key AK, the layout freedom of the display device 100 may be relatively improved.

Additionally, the wiring portion LN may be used as a power wiring for delivering power or as another wirings, thereby increasing the area of the conventional power wirings and reducing wiring resistance.

Below, the manufacturing method of the display device according to the embodiments may be described with reference to FIGS. 5 and 7. The first reflective pattern RP1 and the second reflective pattern RP2 are described in detail, while the manufacturing method for the remaining components of the display area DA may be omitted.

The substrate SUB may be formed on the display area DA and the non-display area NDA entirely.

The pixel circuit layer PCL may be formed on the display area DA of the substrate SUB, and the wiring layer LNL may be formed on the non-display area NDA of the substrate SUB. The pixel circuit layer PCL and the wiring layer LNL may be formed simultaneously in the same process.

The wiring portion LN may be formed on the wiring layer LNL in the non-display area NDA. For example, the metal layer MTL may be formed on the wiring layer LNL, and the metal compound layer MCL may be formed on the metal layer MTL.

In the display area DA, the via layer VIAL may be formed on the pixel circuit layer PCL. In the non-display area NDA, the insulating layer INS may be formed on the wiring portion LN. The via layer VIAL and the insulating layer INS may be formed simultaneously in the same process. However, the embodiments according to the present disclosure are not limited thereto.

In the display area DA, the first to third reflective electrodes RE1 to RE3 may be formed on the via layer VIAL. In the non-display area NDA, the first reflective pattern RP1 may be formed on the insulating layer INS.

In the non-display area NDA, the second reflective pattern RP2 may be formed on the first reflective pattern RP1. The alignment key AK may be formed to penetrate the second reflective pattern RP2 and expose the first reflective pattern RP1.

The display device according to some embodiments may be applied to various electronic devices. An electronic device according to some embodiments includes the display device described above and may further include modules or devices having other additional functions in addition to the display device.

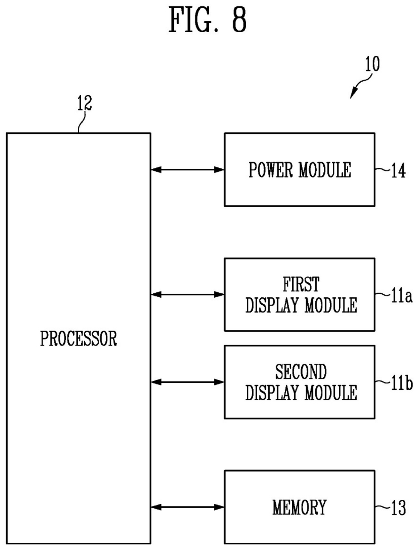

FIG. 8 is a block diagram of an electronic device according to some embodiments of the present disclosure.

Referring to FIG. 8, the electronic device 10 may include first and second display modules 11a, 11b, a processor 12, memory 13, and a power module 14.

The processor 12 may include at least one of a central processing unit (CPU), an application processor (AP), a graphic processing unit (GPU), a communication processor (CP), and an image signal processor (ISP), or a controller.

The memory 13 may store data necessary for the operation of the processor 12 or the first and second display modules 11a, 11b. When the processor 12 executes an application stored in the memory 13, image data and a control signal may be transmitted to the first and second display modules 11a, 11b. The first and second display modules 11a, 11b may process the received image data and the control signal and output image information through their display units.

The power module 14 may include a power supply module such as a power adapter or battery device, and a power conversion module that converts power supplied by the power supply module to generate power required for an operation of the electronic device 10.

In FIG. 8, the electronic device 10 is shown to include first and second display modules 11a, 11b. However, the embodiments according to the present disclosure are not limited thereto, and the electronic device 10 may include one display module or three or more display modules.

At least one of the respective components of the electronic device 10 may be included in the display device according to the embodiments described above. In addition, one or more of individual modules which are functionally included in one module may be included in the display device, and individual modules other than the one or more of the individual modules may be provided separately from the display device. For example, the display device may include the first and second display modules 11a, 11b, and the processor 12, the memory 13, and the power module 14 may be provided in the form of other devices in the electronic device 10 other than the display device. For example, the display device according to the above-described embodiments may be provided as the first and second display modules 11a, 11b, respectively.

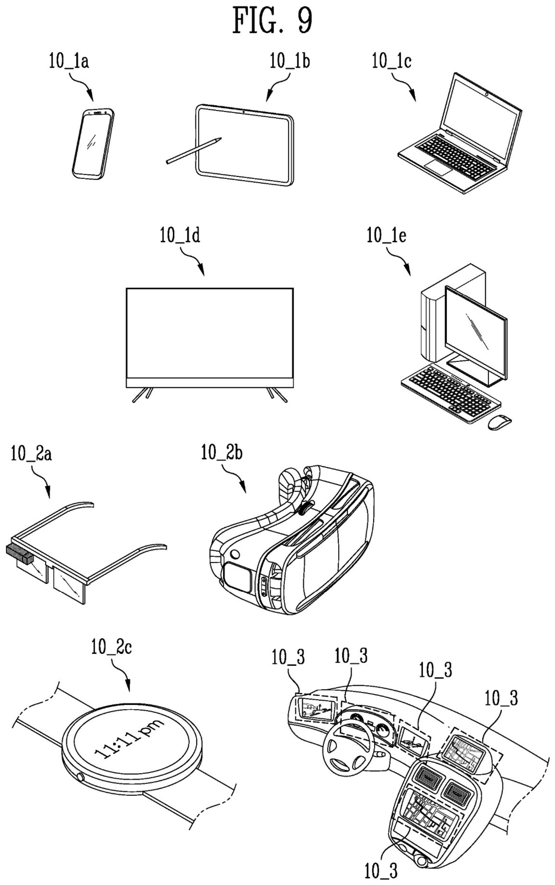

FIG. 9 is a drawing of electronic devices according to some embodiments of the present disclosure.

Referring to FIG. 9, various electronic devices incorporating the display device according to the embodiments may include an electronic device for displaying images, such as a smartphone 10_1a, a tablet PC 10_1b, a laptop 10_1c, a television 10_1d, or a desk monitor 10_1e, as well as a wearable electronic device including a display module such as smart glasses 10_2a, a head-mounted display 10_2b, or a smart watch 10_2c, and an automotive electronic device 10_3 including a display module such as an automotive dashboard, a center fascia, a Center Information Display (CID) placed on a dashboard, or a room mirror display.

When the electronic device may be implemented as the head-mounted display 10_2b, the head-mounted display 10_2b may include the first and second display modules 11a, 11b as described with reference to FIG. 8. The first display module 11a may provide an image to the user's right eye, and the second display module 11b may provide an image to the user's left eye. In such cases, the head-mounted display 10_2b may further include a right-eye lens configured to refract light from the first display module 11a toward the user's right eye, and a left-eye lens configured to refract light from the second display module 11b toward the user's left eye. In the embodiments, the right-eye lens and the left-eye lens may each include an optical lens having a pancake-shaped cross-section. In the embodiments, the right-eye lens and the left-eye lens may each include a multi-channel lens comprising sub-regions having different optical characteristics. In such cases, each of the display panels may output images corresponding to the sub-regions of the multi-channel lens, and the output images may be displayed to the user after passing through the respective sub-regions.

It should be noted that, although the present disclosure is described in detail in accordance with the foregoing embodiments, the foregoing embodiments according to the present disclosure are intended to describe the present disclosure and not to limit the scope of the present disclosure. Those skilled in the art to which the present disclosure pertains may understand that various modifications are possible within the scope of the present disclosure.

The scope of the present disclosure should not be limited to the descriptions mentioned in the detailed description of the specification, but should be determined by the appended claims. In addition, all modifications or variations derived from the meaning and scope of the claims, and equivalents thereof, are to be construed as included within the scope of the present disclosure.

According to some embodiments of the present disclosure, a alignment key may include a first reflective pattern covering a lower wiring portion or a wiring layer and a second reflective pattern exposing the first reflective pattern, thereby enabling the alignment key formed in a recessed pattern to be easily recognized by a difference in reflectivity between the first reflective pattern and the second reflective pattern. As a result, the recognition rate of the alignment key may be relatively improved, thereby relatively enhancing the reliability of the display device.

According to some embodiments of the present disclosure, by designing the first reflective pattern and second reflective pattern that constitute the alignment key and the wiring portion as separate layers, the layout freedom of wirings may be relatively increased.

According to some embodiments of the present disclosure, the wiring portion may be used as power wiring or other wirings, thereby increasing the area of existing power wiring and reducing wiring resistance.

However, the characteristics of embodiments according to the present disclosure are not limited to the characteristics described above, and may be variously extended without departing from the scope of embodiments according to the present disclosure.

## Claims

1. A display device (100), comprising:
a substrate (SUB);
a light-emitting element (LD1, LD2, LD3) on a display area (DA) of the substrate (SUB);
a first reflective pattern (RP1) on the substrate (SUB) and arranged throughout an alignment area (AA) included in a non-display area (NDA) surrounding the display area (DA); and
a second reflective pattern (RP2) on the first reflective pattern (RP1), exposing the first reflective pattern (RP1), including an alignment key (AK) formed in a recessed pattern, and including a material having a different reflectivity from the first reflective pattern (RP1).

2. The display device (100) of claim 1, wherein the alignment key (AK) is defined as an opening penetrating the second reflective pattern (RP2).

3. The display device (100) of claim 1 or claim 2, wherein a reflectivity of the first reflective pattern (RP1) is greater than a reflectivity of the second reflective pattern (RP2).

4. The display device (100) of claim 3, wherein the first reflective pattern (RP1) includes a metal, and the second reflective pattern (RP1) includes a metal compound.

5. The display device (100) of claim 4, wherein the first reflective pattern (RP1) includes aluminium, and the second reflective pattern (RP2) includes titanium nitride.

6. The display device (100) of any one of claims 1 to 5, further comprising:
a wiring portion (LN) between the substrate (SUB) and the first reflective pattern (RP1) and in the non-display area (NDA).

7. The display device (100) of claim 6, wherein the wiring portion (LN) overlaps the first reflective pattern (RP1) and the second reflective pattern (RP2).

8. The display device (100) of claim 6 or claim 7, wherein the wiring portion (LN) includes aluminium.

9. The display device (100) of any one of claims 6 to 8, wherein a thickness (t2) of the wiring portion (LN) is greater than a thickness (t1) of the first reflective pattern (RP1), optionally wherein the thickness of (t1) the first reflective pattern (RP1) is in a range of 500 angstroms to 1000 angstroms.

10. The display device (100) of any one of claims 1 to 9, further comprising
a pixel circuit layer (PCL) between the substrate (SUB) and the light-emitting element (LD1, LD2, LD3) and including a transistor (T_SP11, T_SP12, T_SP13) electrically connected to the light-emitting element (LD1, LD2, LD3).

11. The display device (100) of claim 10, further comprising:
a reflective electrode (RE1, RE2, RE3) between the pixel circuit layer (PCL) and the light-emitting element (LD1, LD2, LD3) and electrically connected to the transistor (T_SP11, T_SP12, T_SP13) and the light-emitting element (LD1, LD2, LD3).

12. The display device (100) of claim 11, wherein:
(i) the light-emitting element (LD1, LD2, LD3) comprises:
an anode electrode (AE1, AE2, AE3) on the reflective electrode (RE1, RE2, RE3) and electrically connected to the reflective electrode (RE1, RE2, RE3);
an emission structure (EMS) on the anode electrode (AE1, AE2, AE3); and
a cathode electrode (CE) on the emission structure (EMS); and/or
(ii) the reflective electrode (RE1, RE2, RE3) is on a same layer as the first reflective pattern (RP1) and includes a same material as the first reflective pattern (RP1); and/or
(iii) the reflective electrode (RE1, RE2, RE3) includes aluminium.

13. The display device (100) of any one of claims 1 to 12,
wherein edge ends of the first reflective pattern (RP1) and edge ends of the second reflective pattern (RP2) align with each other.

14. An electronic device (10), comprising:
a processor (12); and
a display device (100) configured to display an image under control of the processor (12),
wherein the display device (100) comprises:
a substrate (SUB);
a light-emitting element (LD1, LD2, LD3) on a display area (DA) of the substrate (SUB);
a first reflective pattern (RP1) on the substrate (SUB) and arranged throughout an alignment area (AA) included in a non-display area (NDA) surrounding the display area (DA); and
a second reflective pattern (RP2) on the first reflective pattern (RP1), exposing the first reflective pattern (RP1), including an alignment key (AK) formed in a recessed pattern, and including a material having a different reflectivity from the first reflective pattern (RP1).

15. The electronic device (10) of claim 14, wherein:
(i) the alignment key (AK) is be defined as an opening penetrating the second reflective pattern (RP2); and/or
(ii) a reflectivity of the first reflective pattern (RP1) is greater than a reflectivity of the second reflective pattern (RP2); and/or
(iii) edge ends of the first reflective pattern (RP1) and edge ends of the second reflective pattern (R2) align with each other.
